# EUROPÄISCHE PATENTSCHRIFT

(11) **EP 0 486 943 B1**
(45) Veröffentlichungstag und Bekanntmachung des Hinweises auf die Patenterteilung: **15.02.1995**
(21) Anmeldenummer: 91119433.0
(22) Anmeldetag: 14.11.1991
(51) Int. Cl.: H01P 5/12, H01P 5/08, H01J 37/32

(54) **Vorrichtung für die Erzeugung eines regelmässigen Mikrowellenfeldes**
Device for the excitation of a uniform microwave field
Dispositif pour l'excitation d'un champ à micro-ondes uniforme

(30) Priorität: 22.11.1990 DE 4037091
(43) Veröffentlichungstag der Anmeldung: 27.05.1992
(73) Patentinhaber: LEYBOLD AKTIENGESELLSCHAFT, D-63450 Hanau (DE)
(72) Erfinder: Geisler, Michael, Dr., W-6480 Wächtersbach (DE); Jung, Michael, Dipl.-Ing., W-8756 Kahl (Main) (DE); Kessler, Bernhard, Dipl.-Ing., W-6450 Hanau-Wolfgang (DE); Leuterer, Fritz, Dipl.-Ing., W-8037 Olching (DE); Münich, Max, Dipl.-Ing., W-8050 Freising (DE); Wilhelm, Rolf, Dipl.-Phys., W-8000 München 45 (DE)
(74) Vertreter: Schickedanz, Willi, Dipl.-Ing.

(56) Entgegenhaltungen:
- EP-A- 0 285 020
- EP-A- 0 382 065
- FR-A- 2 312 165
- FR-A- 2 489 647
- FR-A- 2 520 160
- US-A- 2 566 386
- US-A- 4 006 339
- JOURNAL OF VACUUM SCIENCE AND TECHNOLOGY: PART A. Bd. 8, Nr. 2, Februar 1990,NEW YORK US Seiten 908 - 915; M.GEISLER ET AL.: 'Elongated microwave cyclotron resonance heating plasma source'

## Beschreibung

Die Erfindung betrifft eine Vorrichtung nach dem Oberbegriff des Patentanspruchs 1.

Bei der Erzeugung von Plasmen, die für die Beschichtung von Materialien und andere Zwecke verwendet werden, werden in verstärktem Maße Mikrowellen eingesetzt, die in Verbindung mit Magnetfeldern eine Elektronen-Zyklotron-Resonanz und damit eine erhöhte Ionisierung von Atomen oder Molekülen bewirken. Von besonderem Interesse sind solche Plasmaquellen, die möglichst gleichmäßig und großflächig ausgebildet sind, damit viele kleine oder wenige große Flächen gleichzeitig beschichtet werden können. Insbesondere die glimmentladungsunterstützte chemische Abscheidung aus der Gasphase, genannt PCVD (= Plasma Enhanced Chemical Vapor Deposition), die als Alternative bzw. Ergänzung zur bekannten Sputter- oder Aufdampftechnik bei der Großflächenbeschichtung verwendet wird, erfordert eine sehr gleichmäßige Niederdruckglimmentladung zumindest in Richtung der größten Ausdehnung der Beschichtungsanlage.

Es ist bereits eine Mikrowellen-Breitstrahl-Ionenquelle bekannt, bei welcher die Mikrowellen über einen E₀₁-Rundhohlleiter einem E₀₁₀-Hohlraumresonator zugeführt werden, der von einer Magnetspule umgeben und mit zu ionisierendem Gas gefüllt ist (DD-PS 248 904). Den Boden des Hohlraumresonators bildet eine Emissionselektrode, die zusammen mit einer Extraktionselektrode ein Extraktionssystem bildet, an welches eine Vakuumkammer anschließt. Nachteilig ist bei dieser Ionenquelle, daß die Mikrowellenenergie ungleichmäßig vom Rundhohlleiter in den Hohlraumresonator eingestrahlt wird. Da der Rundhohlleiter kleiner als der Hohlraumresonator ist, strahlen die Mikrowellen nur in einen relativ kleinen Bereich ein.

Zur Homogenisierung von großflächigen Mikrowelleneinstrahlungen sind bereits Hohlraumresonator-Antennen bekannt, die im Resonator runde oder rechteckige Öffnungen (Jacobsen, S. et al.: An Antenna Illuminated by a Cavity Resonator, In: Proc. of the IEEE, November 1963, S. 1431 bis 1435, DE-A-35 30 647) oder Schlitze ( GB-A-654 224, US-A-2 996 715, DE-C-29 00 617, US-A-4 512 868, CH-PS'en 370 177, 368 248, 363 742, Patents Abstracts of Japan, E-570, January 7, 1988, Vol. 12/No. 3, Veröff.Nr. 62-165 403) oder Quarzscheiben (EP-A-0 183 561, EP-A-0 286 132) aufweisen. Eine Übertragung elektromagnetischer Energie vom Hohlraumresonator in einen räumlich getrennten Plasmaraum ist mit diesen bekannten Einrichtungen indessen nicht möglich.

Es ist weiterhin eine Plasma-Ätzvorrichtung bekannt, die einen Mikrowellen-Generator aufweist, der an einen Rechteckhohlleiter angekoppelt ist (DE-C-27 16 592, Fig. 1). In einer Stellung, die etwa 1/4 einer Hohlleiter-Wellenlänge vom Abschlußende dieses Rechteckhohlleiters entfernt ist, ragt das Ende eines Innenleiters einer koaxialen Wellenleitung in den Hohlleiter. Über die auf diese Weise gebildete Antenne breitet sich die Mikrowelle des Hohlleiters auch im koaxialen Wellenleiter aus. Darüber hinaus breitet sich ein elektrisches Feld der Mikrowellen über einen Isolator als auch eine zwischen den Mikrowellen und einem Plasma koppelnde Kopplungseinrichtung in einem Entladestrom aus. Bei dem Hohlleiter, der mit dem Mikrowellen-Generator in Verbindung steht, handelt es sich nicht um einen Hohlraumresonator. Außerdem ist der Innenleiter nur einfach vorgesehen und direkt durch die Trennwand zwischen Hohlleiter und Entladestrom geschleift

Schließlich ist auch noch eine Einrichtung zur Erzeugung von Mikrowellenplasmen mit großer Ausdehnung und Homogenität bekannt, die einen Mikrowellenerzeuger, einen Hohlraumresonator, eine Ankopplung für den Mikrowellenerzeuger an den Hohlraumresonator, eine mit Wänden begrenzte Kammer, eine Trennwand zwischen dem Hohlraumresonator und der Kammer und eine aus mehreren als Festkörper ausgebildeten Koppelelementen bestehende Koppeleinrichtung aufweist (DD-A-263 648). Bei den Koppelelementen handelt es sich hierbei um metallische Koppelhaken, die über Koppellöcher aus dem die Mikrowelle heranführenden Wellenleiter in einen anderen Wellenleiter hineinragen, an den sich eine Plasmakammer anschließt. Wesentlicher Bestandteil dieser bekannten Mikrowellenplasmaversorgung ist die durch einen angepaßten Absorber abgeschlossene Leitung, welche vakuum- bzw. plasmaseitig die in einer Reihe angeordneten Koppelelemente verbindet oder verkoppelt. Diese Verkopplung stellt einen Nachteil dar, weil die einzelnen Mikrowellenantennen voneinander möglichst entkoppelt und nicht miteinander verkoppelt sein sollen. Die plasmaseitige Kopplung der Antennen macht die Entkopplung wieder zunichte, die durch die Speisung der Antennen aus einem Resonator hoher Güte erzielt wird. Um die Einzelantennen herum bilden sich Bereiche intensiven Plasmas aus, in denen die Elektronendichte ihren für die Anregungsfrequenz kritischen Wert von 0,75 x 10⁻¹² cm⁻³ erreicht. Das bedeutet, däß ein großer Teil der in die vakuumseitige Antenne eingespeisten Leistung vom Plasma vollständig reflektiert wird.

Der Erfindung liegt die Aufgabe zugrunde, eine Vorrichtung mit Mikrowellehkopplern zu schaffen, welche es gestattet, Mikrowellen als homogene Felder großflächig in einen Raum einzustrahlen, wobei in diesem Raum die Mikrowellenkoppler relativ zueinander entkoppelt sind.

Diese Aufgabe wird gemäß den Merkmalen des Anspruchs 1 gelöst.

Der mit der Erfindung erzielte Vorteil besteht insbesondere darin, daß sich eine große Regelmäßigkeit des Nahfeldes der Mikrowellen-Einspeisungsantenne ergibt. Eine besonders stabile und gleichmäßige Nahfeldverteilung ergibt sich bei Resonatorlängen bis zu 1 m und länger und Entladungsdrücken ≧ 1 Pa. In Verbindung mit einer Plasmakammer führt diese Regelmäßigkeit zu einer Gleichmäßigkeit der Plasmaverteilung. Plasmazonenlängen, die größer als 1 m sind, lassen sich mit der Erfindung leicht erzielen. Desgleichen können für Glimmentladungen, wie sie in der PCVD-Technik üblich sind, Mikrowellenleistungsdichten in der Größenordnung von 4 W/cm² eingestrahlt werden.

Weiterhin erfordert die Erfindung kein dielektrisches Bauteil, das vom Plasma oder anderen im Rezipienten untergebrachten Quellen beschichtet werden könnte. Mit der Erfindung ist es auch möglich, mehrere Einzel-Mikrowellenquellen parallel einzuspeisen.

Außerdem wird mit der Erfindung eine plasmaseitige Entkopplung der Antennen dadurch erreicht, daß ihnen z. B. eine Biegung in Richtung auf den in ausreichender Nähe befindliches Magnetsystem hin verliehen wird, wobei dieses Magnetsystem vorzugsweise die Bedingungen der Elektronen-Zyklotron-Resonanz (ECR) erfüllt. Magnetsystem und Antennen sind so zueinander angeordnet, daß die Antennen möglichst direkt in das sich auf oder über dem Magnetsystem ausbildenden Plasma abstrahlen. Aufgrund des ECR-Effekts wird somit ein erheblicher Teil der elektromagnetischen Strahlung absorbiert, bevor es in den Bereich der Nachbarantenne eindringt und damit eine Verkopplung der benachbarten Antenne bewirkt.

Ausführungsbeispiele der Erfindung sind in den Zeichnungen dargestellt und werden im folgenden näher beschrieben. Es zeigen:
- Fig. 1: das Prinzip einer Mikrowelleneinspeisung in einen Hohlraumresonator mit Mikrowellenauskopplung;
- Fig. 2a: einen Hohlraumresonator mit mehreren Auskoppelelementen;
- Fig. 2b: eine Darstellung des Feldes bzw. der Felder, das sich im Hohlraumresonator gemäß Fig. 2a ausbildet;
- Fig. 3: einen Schnitt durch den Hohlraumresonator und eine Plasmakammer;
- Fig. 4: ein induktives Ankoppelelement in perspektivischer Darstellung;
- Fig. 5: eine Schnittdarstellung des induktiven Ankoppelelements gemäß Fig. 4;
- Fig. 6: eine Anordnung mit einem Hohlleiterresonator, der obere und untere Koppelelemente aufweist;
- Fig. 7: eine Anordnung, bei der die Koppelelemente zwischen ungleichnamigen Dauermagneten liegen.

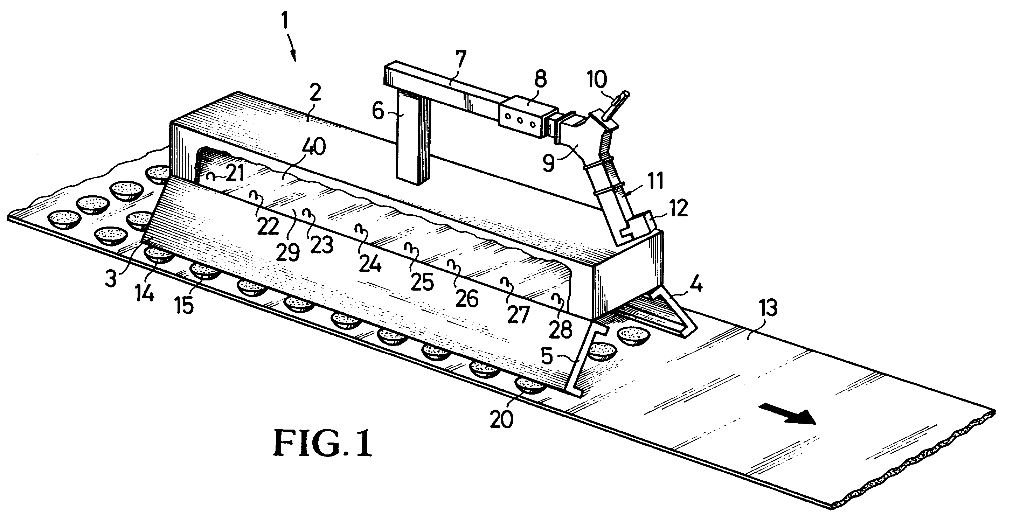

In der Fig. 1 ist das Prinzip einer Beschichtungsanlage 1 dargestellt, die einen mit Luft gefüllten Hohlraumresonator 2 für Mikrowellen, eine Vakuum-Plasmakammer 3 mit Dauermagnete tragenden Magnetjochen 4,5 und einen Rechteck-Hohlleiter 6 für die Einspeisung von Mikrowellen aufweist. Der Rechteckhohlleiter 6 ist mit einem weiteren Rechteckhohlleiter 7 verbunden, der seinerseits über einen Impedanztransformator 8 an einem Zirkulator 9 liegt. Der Zirkulator 9 weist einen - hier symbolisch dargestellten - Anpassungswiderstand 10 auf, bei dem es sich um einen angepaßten Absorber und eine Leistungsmessung handeln kann, und ist über ein Anschlußstück 11 mit einem Mikrowellengenerator 12, beispielsweise einer Magnetron-Röhre, verbunden. Die Betriebsfrequenz des Mikrowellengenerators 12 beträgt z. B. 2,45 GHz oder 915 MHz.

Unterhalb der Plasmakammer ist ein Förderband 13 vorgesehen, auf dem mehrere zu beschichtende Gegenstände 14 bis 20 angeordnet sind. Als für die Erfindung wesentliche Elemente sind zahlreiche linear hintereinander angeordnete Wellenkoppler 21 bis 28 vorgesehen, die man durch den aufgebrochenen Bereich 40 des Resonators 2 erkennt und die mit einem oberen Teil in dem Rechteckhohlleiter 2 und mit einem unteren Teil in die Plasmakammer 3 hineinragen. Diese Wellenkoppler 21 bis 28 koppeln Mikrowellenenergie aus dem Hohlraumresonator 2 durch eine feste Metallwand 29 in die Plasmakammer 3 ein.

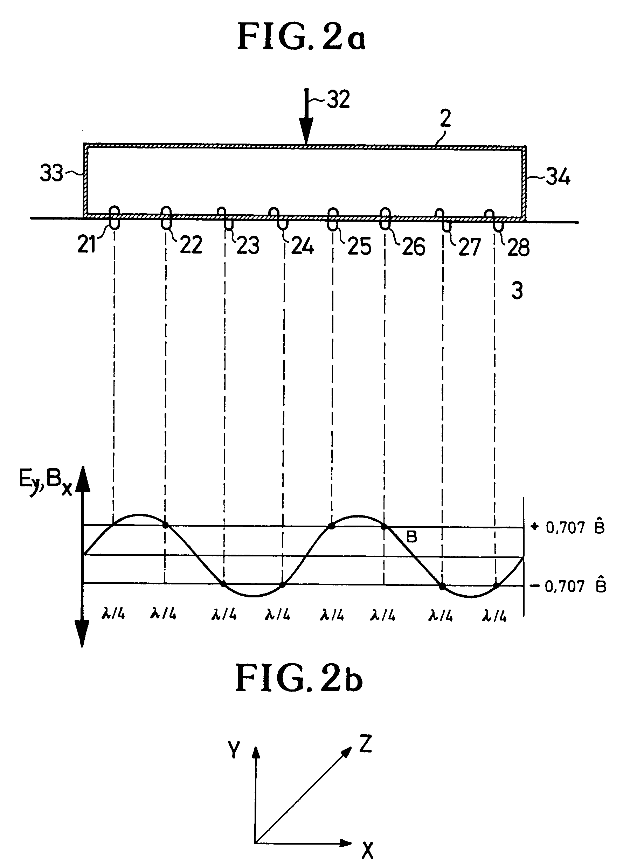

In der Fig. 2a ist der Hohlraumresonator 2 noch einmal im Prinzip dargestellt. Während sich in diesem Hohlraumresonator 2 vorzugsweise Luft befindet, ist unterhalb des Resonators 2, also in der Plasmakammer 4, Vakuum vorhanden. Die Einspeisung der Mikrowellenenergie in den Hohlraumresonator 2 ist durch einen Pfeil 32 angedeutet.

Unterhalb des Hohlraumresonators 2 sind die stehenden E- und B-Felder dargestellt, die sich zwischen den Seitenwänden 33, 34 des Resonators 2 ausbilden. Der Resonator besteht hierbei z. B. aus einem 1 m langen Rechteckrohr. An einem Ende kann er eine nicht dargestellte Kurzschlußplatte und am anderen Ende einen nicht dargestellten Kurzschlußschieber aufweisen. Mit diesem Schieber läßt sich die Resonanzfrequenz einstellen. Allein die Dimensionen des Resonators 2 bestimmen bei gegebener Frequenz und Dielektrizitätskonstante das Feldbild und damit die sich ergebende Resonanzfrequenz. Das sinusförmige B-und E-Feld wird bei den positiven und negativen 0,707-Werten der Sinushalbwellen kapazitiv bzw. induktiv angezapft. Pro Halbwelle finden somit vorzugsweise zwei Anzapfungen statt. Dabei wird die positive Halbwelle anders angezapft als die negative Halbwelle, um eine Phasendrehung zu erhalten. Für z. B. die induktive Anzapfung ist bei der positiven Halbwelle ein erster Kopplungssteg 21, 22 vorgesehen, während für die negative Halbwelle ein zweiter Kopplungssteg 23, 24 vorgesehen ist. Die Positionen der Koppelelemente 21 bis 28 stimmen mit den Orten überein, wo die Amplitude des elektrischen oder des magnetischen Wechselfeldes das 0,7-Fache seines Maximums besitzt, so daß alle Koppler 21 bis 28 dieselbe Feldstärkenamplitude und Leistung auskoppeln.

Obgleich diese Anordnung besonders vorteilhaft ist, ist die Erfindung dennoch nicht hierauf beschränkt. Die Koppler können das überkoppelte Feld auch um eine Phase beliebigen Betrags drehen, so däß sie nicht im λ/4-Abstand angeordnet sein müssen. Auch die Koppeldämpfungen müssen nicht gleich sein.

Die Koppler sind bei der bevorzugten Ausführungsform so angeordnet, daß die Mitten zwischen zwei beliebigen gleichartigen Kopplern die gleiche Längskoordinate besitzen wie die Extrema der stehenden Welle innerhalb des Resonators 2. Die Koppler 21 bis 28 führen die Mikrowellenenergie aus dem Hohlraumresonator 2, in dem sich Luft befindet, in die Plasma-oder Vakuumkammer 3 ein. Bei induktiver Einkopplung können sie deshalb als eine Art von Transformatoren angesehen werden.

Durch die äquidistante und lineare Anordnung der Koppler, die vorzugsweise noch gleiche Dämpfung besitzen, wird eine in erster Näherung ebene Wellenfront aufgebaut, die sich aus dem Huygens'schen Prinzip ergibt. Eine ebene Welle entsteht hiernach durch die geeignete Überlagerung der Wellen zahlreicher punktförmiger Wellenerzeuger. Während ein einziger punktförmiger Wellenerzeuger eine Kugelwelle erzeugt, ergibt sich aus der Überlagerung zahlreicher Kugelwellen eine ebene Welle, wenn der Abstand der Wellenerzeuger viel kleiner als λ/2 ist.

Eine solche ebene Welle wird durch die verschiedenen Koppler 21 bis 28, die als Punktquellen anzusehen sind, auf die Plasmakammer 3 gestralt, so daß sich ein regelmäßiges und gleichmäßiges Nutzfeld ergibt. Die Auskoppler 21 bis 28 wirken in ihrer Gesamtheit wie eine Antenne, die eine ebene Welle abstrahlt. Vom räumlichen Aufbau der Antenne her besteht eine gewisse Verwandtschaft zu den Phased-Array-Antennen, wie sie aus der Radartechnik bekannt sind (vgl. E. Pehl: Mikrowellentechnik, Band 2, Antennen und aktive Bauteile, 2. Auflage, 1989, S. 79 ff.).

Um die Phasenumkehr bei der induktiven Auskopplung der negativen Halbwelle im Vergleich zur positiven Halbwelle zu erreichen, kann der Windungssinn einer Auskoppelschleife geändert werden. Da die Magnetfeldlinien im Hohlleiter bei jeweils einer anderen Phase eine andere Richtung haben, fließt in einer Schleife der induzierte Strom ein eine andere Richtung. Werden die Schleifen in Abhängigkeit von der jeweiligen Halbwelle unterschiedlich aus dem Hohlleiter herausgeführt, fließen die Ströme alle in derselben Richtung.

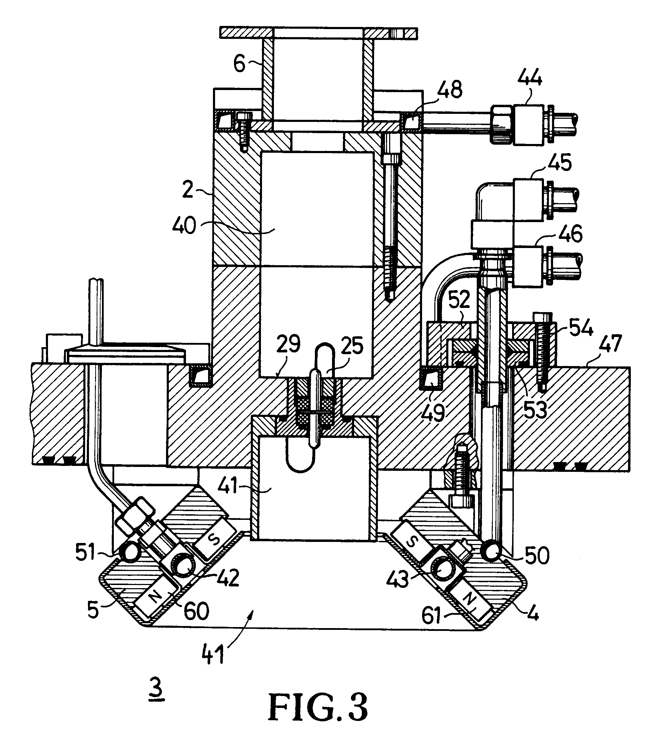

In der Fig. 3 ist ein Schnitt durch einen Hohlraumresonator 2 und eine Plasmakammer 3 dargestellt. Man erkennt hierbei einen Plasmaraum 41, in den über den Hohlleiter 6 Mikrowellenenergie aus einer nicht dargestellten Mikrowellenquelle eingespeist wird. Die sich im Innenraum 40 des Hohlraumresonators 2 ausbildende stehende Welle wird über die Koppler 21 bis 28, von denen in der Fig. 3 nur ein Koppler 25 erkennbar ist, in den Innenraum 41 der Plasmakammer 3 eingekoppelt. In diesen Innenraum 41 gelangt außerdem über Rohre 42,43 ein Gas oder Gasgemisch, das ionisiert werden soll. Die Ionisierung wird nicht nur durch die eintretenden Mikrowellen bewirkt, sondern auch durch die Magnetfelder, die durch die Magnetsysteme 4,5 mit den Dauermagneten 60,61 erzeugt werden. Durch das Zusammenwirken der Mikrowelle mit den entsprechend dimensionierten Magnetfeldern entsteht eine Elektronen-Zyklotron-Resonanz, welche die Ionisierung verstärkt. Die Plasmakammer 3, die Magnetsysteme 4,5 und auch der Resonator 2 werden während des Betriebs erhitzt, so daß sie gekühlt werden müssen. Hierfür ist eine Wasserkühlung vorgesehen, deren Kühlrohre 44 bis 46 zu Kühlringen 48 bis 51 führen. Für die Befestigung des Kühlrohrs 45, das zu den Magnetsystemen 4,5 führt, ist ein Flansch 47 an der Plasmakammer 2 vorgesehen, der Rohrführungen 52, 54 bzw. Dichtungen 53 trägt. Vom Rechteck-Hohlleiter 6 zum Hohlraumresonator 2 ist eine in der Fig. 3 nicht dargestellte Koppelschleife vorgesehen.

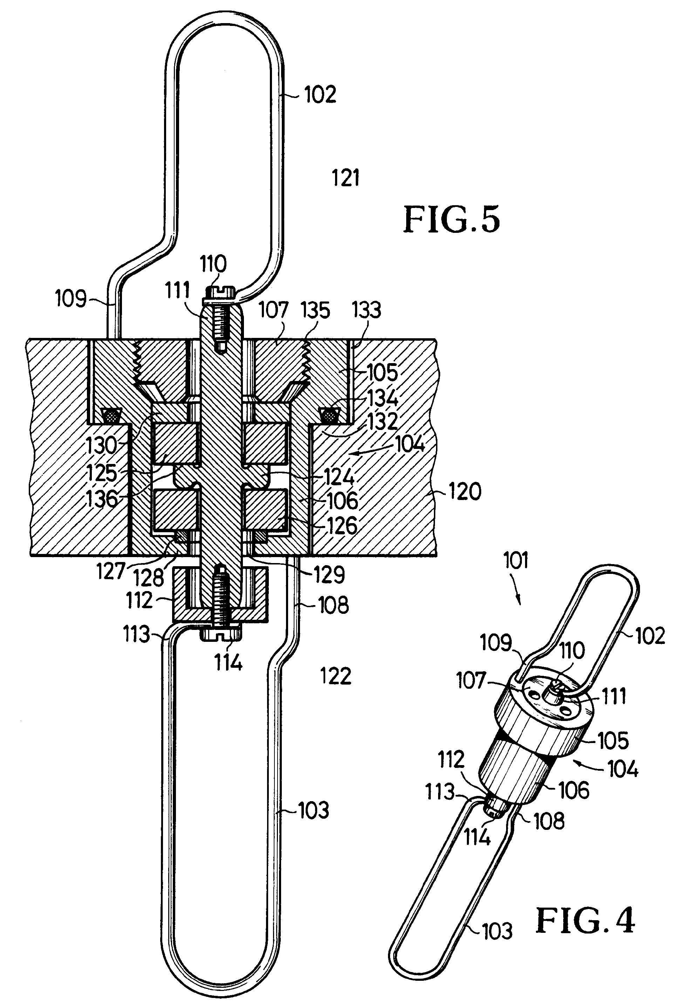

In den Fig. 4 und 5 ist eine Vorrichtung zum Auskoppeln von großer Mikrowellenleistung aus einem ersten Raum in einen zweiten Raum dargestellt, bei der ein optisch durchsichtiges Medium zwischen beiden Räumen nicht erforderlich ist und bei welcher eine Überhitzung und nachteilige Beschichtung der Auskoppelvorrichtung vermieden wird.

Der mit dieser Vorrichtung erzielte Vorteil besteht insbesondere darin, daß die Auskoppler und/oder die Trennwand zwischen den beiden Räumen nur eine sehr geringe Eigenerwärmung haben. Außerdem werden eine Verschmutzung des Auskopplers im Plasmaraum sowie ein Zünden einer Entladung in der Vakuumdurchführung zwischen Primär- und Sekundärteil des Auskopplers verhindert.

In der Fig. 4 ist ein erfindungsgemäßes Koppelelement 101 dargestellt, das eine Primärantenne 102 und eine Sekundärantenne 103 aufweist. Zwischen den beiden Antennen befindet sich eine Buchse 104, die einen oberen Teil 105 mit großem Außendurchmesser und einen unteren Teil 106 mit kleinem Außendurchmesser aufweist. Die obere Buchse 105 wird durch eine Verschlußschraube 107 abgeschlossen, deren Außengewinde in ein Innengewinde des Teils 105 der Buchse 104 eingreift.

Die Primärantenne 102 und die Sekundärantenne 103 besitzen die Form einer offenen Schleife, wobei jeweils ein Ende 108, 109 der Schleifen mit der Buchse 104 verbunden ist Das andere Ende der Schleife der Primärantenne 102 ist über eine Schraube 110 mit einem Ende einer Mittelelektrode 111 verbunden, während das andere Ende dieser Mittelelektrode 111 mit einer Dunkelraumkappe 112 in Verbindung steht, an die das andere Ende 113 der Sekundärantenne 103 angeschlossen ist. Die Verbindung zwischen Dunkelraumkappe 112, Sekundärantenne 103 und Mittelelektrode 111 erfolgt über eine Schraube 114.

Das in der Fig. 4 dargestellte Koppelelement 101 kann einzeln oder mit mehreren gleichartigen Koppelelementen zusammen in einer Trennwand zwischen einen Plasmaraum und einen Mikrowellenraum eingeschoben werden.

In der Fig. 5 ist das Koppelelement 101 gemäß Fig. 4 noch einmal im Schnitt dargestellt, wobei dieses Koppelelement 101 in eine Trennwand 120 eingesetzt ist. Oberhalb der Trennwand 120, d. h. im Raum 121 befindet sich z. B. Luft, während im Raum 122 unterhalb der Trennwand 120 Plasma vorhanden ist. In den Raum 121, der z. B. ein Hohlraumresonator ist, breitet sich eine Mikrowelle aus, und zwar vorzugsweise als stehende Welle. Aus dieser stehenden Welle wird Mikrowellenenergie durch die Primärantenne 102 ausgekoppelt und durch die Sekundärantenne 103 in das Plasma des Raums 122 eingekoppelt.

Beide Antennen 102, 103 sind über eine Mittelelektrode 111 miteinander verbunden, welche die Form eines Stifts hat, der etwa in seinem mittleren Bereich einen Kragen 124 aufweist. Oberhalb und unterhalb dieses Kragens 124 sind jeweils eine Keramikscheibe 125, 126 angeordnet, wobei sich die untere Keramikscheibe 126 über eine Dichtung 127 auf dem Boden 128 der Buchse 104, der eine Öffnung 129 aufweist, abstützt.

Oberhalb der oberen Keramikscheibe 125 ist eine Einpreßscheibe 130 vorgesehen, über der sich eine Verschlußschraube 107 befindet, die mit ihrem Außengewinde in das Innengewinde des oberen Teils 105 der Buchse 104 eingreift. Der obere Teil 105 der Buchse sitzt auf einem Vorsprung 132 einer Durchbohrung 133 der Trennwand 120 auf, und zwar über eine Elastomer-Dichtung 134. Die Abdichtung zwischen der Atmosphäre im Raum 121 und dem Vakuum im Raum 122 wird im wesentlichen durch die Elemente 124, 126, 127 und 128 bewirkt. Die Keramikscheibe 125 dient zur Kraftübertragung und zur Isolation zwischen der Mittelelektrode 111 und der Einpreßscheibe 130. Die Einpreßscheibe 130, die aus Weichmetall, z. B. Silber, Kupfer oder Aluminium, besteht, wird zudem in die wesentlich härtere Oberfläche der Keramikscheibe 125 gepreßt, was zu einem sehr intensiven Oberflächenkontakt zwischen der Einpreßscheibe 130 und der Oberfläche der Keramikscheibe 125 führt Durch eine solche Verbindung lassen sich Dichtungssysteme mit einer Leckrate deutlich kleiner als 10 x 10⁻⁸ mbar ℓ/s für Helium herstellen.

Die Preßkraft, die auf die Einpreßscheibe 130 einwirkt, wird mit der Verschlußschraube 107 aufgedrückt. Hierzu wird die Einpreßscheibe 130, deren Außendurchmesser ein Übermaß gegenüber der Bohrung 135 in der Buchse 104 besitzt, zunächst mittels einer Vorrichtung eingepreßt. Dreht man die Verschlußschraube 107 weiter, wird die Kombination aus Metalldichtung 130, untere Keramikscheibe 126, Kragen 124 der Mittelelektrode 111, obere Keramikscheibe 125 und Einpreßscheibe 130 gespannt. Bei weiterer Steigerung des Anzugsmoments der Verschlußschraube 107 setzt zunächst die Verformung an der Dichtkante 136 des Kragens 124 an der Mittelelektrode 111 ein. Wird weiter gespannt, verformt sich auch der Metalldichtring 127. Die Flächenbelastung in dem Paket aus Metalldichtung 127, unterer Keramikscheibe 126, Mittelelektrode 111, oberer Keramikscheibe 125 und Einpreßscheibe 130 ist derart ausgelegt, daß nur an den Dichtflächen eine Verformung der Metallflächen in der beschriebenen Reihenfolge stattfindet.

Als Keramikscheiben 125, 126 werden vorzugsweise solche aus Al₂O₃ verwendet, das eine Wärmeleitfähigkeit λ hat, die etwa zehnmal geringer ist als die Wärmeleitfähigkeit λ der Mittelelektrode 111. Um eine sichere Ableitung der Wärmemenge, die der Querschnitt der Mittelelektrode 111 aus Metall übertragen kann, sicherzustellen, muß eine entsprechend große Fläche an der Keramikscheibe 125, 126 zur Wärmeübertragung benutzt werden. Diese Fläche wird durch den Kragen 124 der Mittelelektrode 111 zur Verfügung gestellt, da Ober- und Unterseite des Kragens 124 in gutem, flächigen Kontakt mit den Keramikscheiben 125, 126 stehen.

Die Wärmeableitung oberhalb bzw. unterhalb der Keramikscheiben 125, 126 wird einerseits von der Einpreßscheibe 130 und andererseits von der Metalldichtung 127 übernommen. Die Kompensation der leicht unterschiedlichen Wärmeausdehnungseigenschaften der Materialien der Dichtelektrode 111 und der Dichtringe 130, 125, 126, 127 einerseits und des Materials der Buchse 104 andererseits wird durch das Verhältnis zwischen der Dicke des Kragens 124 der Mittelelektrode 111 und der Dicke der Keramikscheiben 125, 126 eingestellt. Eine durch unterschiedliche Wärmedehnung der Keramik-Metallverbindung mögliche Verschiebung der Dichtflächen gegeneinander wird durch eine ausgeprägte Verzahnung bei gleichzeitig hohen Preßkräften, die auf diese Flächen wirken, verhindert. Die Einpreßscheibe 130 kann auch als Federelement, z. B. aus Kupferberyllium, ausgebildet sein, um die Spannkräfte auch nach erheblichen thermischen Überlastungen des Kopplers 101 zu sichern.

Der Außendurchmesser der Einpreßscheibe 130 wächst durch den Preßvorgang. Dadurch wird zwischen dem Außenrand der Einpreßscheibe 130 und der Innenwand der Buchse 104 ein sicherer und mikrowellentechnisch brauchbarer Kontakt hergestellt. Die Einpreßscheibe 130 verhält sich daher mikrowellentechnisch wie der Boden der Buchse 104. Die Elastomer-Dichtung 134, die durch die Abdichtung des Koppelelements 101 zur Trennwand 120 hin erfolgt, wird durch eine metallische Kassette, gebildet aus einer Dichtnut an der Buchse 105 und einer Dichtfläche 132 an der Trennwand 120, vor Mikrowellenfeldern abgeschirmt und dadurch vor Zerstörung geschützt. Gleichzeitig dient dieser durch Schrauben angepreßte metallische Kontakt der Buchse 105 zur Übertragung von Wärme.

Durch das erfindungsgemäße Koppelelement 101 können Innen- und Außendurchmesser der koaxialen Durchführung durch die Trennwand 120 in weiten Grenzen geändert werden. Beispielsweise können der Durchmesser der Mittelelektrode 111, deren Kragen 124, der Durchmesser der Keramikscheiben 125, 126, die Bohrungen in der Verschlußschraube 107 oder im Boden der Buchse 104 so gewählt werden, daß der koaxialen Durchführung ein Wellenwiderstand zugeordnet werden kann. Die elektrische Länge der koaxialen Durchführung beträgt vorzugsweise λ/2.

Die Dunkelraumkappe 112 besteht aus metallischem Material und ist so gestaltet, daß sie ein Eindringen von Ladungsträgern aus dem Plasma in die Isolationsspalte der koaxialen Durchführung verhindert. Damit wird die Aufrechterhaltung einer unselbständigen Entladung im Isolationsspalt unterbunden. Ferner sind die Spalten zwischen dem Koppelelement 101 und der Trennwand 120 durch Einhaltung des Dunkelraumabstands so dimensioniert, daß auch eine selbständige Entladung innerhalb eines weiten Druckbereichs nicht existieren kann. Die Dunkelraumkappe 112 verhindert zudem dauerhaft eine Beschichtung bzw. Verschmutzung des Koppelelements 101. Oberteil 105 und Unterteil 106 des Koppelelements 101 lassen sich durch mechanische Reinigungsmethoden, z. B. durch Abbürsten, Glasperlenstrahlen etc., problemlos reinigen. Die Topf- oder Glockenform der Dunkelraumkappe 112 hat sich zudem mikrowellentechnisch bewährt.

Sowohl die Primärantenne 102 als auch die Sekundärantenne 103 können als H-Schleife mit ℓ/λ << 1, wobei ℓ die abgewickelte Länge der Antennenschleife ist, als auch als Ringantenne bzw. Faltdipolantenne mit ℓ/λ ≈ > 1 oder auch als kapazitive Koppelstifte ausgebildet werden. Vorzugsweise werden die Antennen 102, 103 als Ringantennen ausgeführt. Dabei sollen sowohl der ansteigende als auch der absteigende Antennenteil keine größeren Krümmungen aufweisen und bereichsweise möglichst parallel verlaufen. Die Fußpunkte der Antennen 102, 103 können aufgeschraubt, gelötet, geschweißt oder geklemmt werden. Radien und Längen, d. h. die Geometrie der Antennen 102, 103 sind so gewählt, daß im Bereich der Dunkelraumkappe 112 und weitgehend auch im anschließenden Teil des Koppelelements 101 die Spannungen auf den Antennen bzw. auf der Mittelelektrode 111 gering sind.

Die Koppeldämpfung zwischen dem durch den Raum 121 symbolisierten Hohlleiter-Resonator und einem durch den Raum 122 symbolisierten PCVD-Reaktor kann durch die Größe der Primärantenne 102 oder auch durch deren Orientierung relativ zur Achse des Hohlleiter-Resonators eingestellt werden.

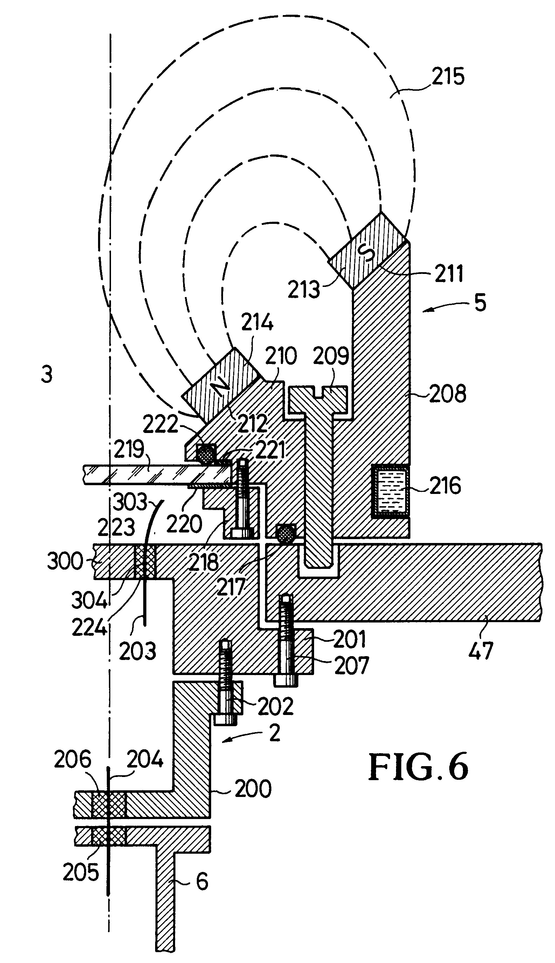

In der Fig. 6 ist ein Teilschnitt durch einen Hohlraumresonator 2 gezeigt, welcher mit der Ansicht der Fig. 3 vorgleichbar ist, wenn diese um 180° gedreht wird. Der aus einem metallischen Material bestehende Hohlraumresonator 2 weist hierbei zwei Hälften 200, 201 auf, die über Verbindungselemente 202 miteinander verbindbar sind. In der oberen Hälfte sind mehrere Koppelschleifen eingeführt, von denen in der Fig. 6 nur eine Koppelschleife 203 zu erkennen ist. Diese Koppelschleifen sind in die Zeichenebene hinein hintereinander angeordnet. Eine einzelne Koppelschleife hat etwa das Aussehen einer Koppelschleife 25 gemäß Fig. 3, wobei jedoch die beiden Stege der Schleife senkrecht zur Zeichenebene angeordnet sind.

Die untere Hälfte 200 des Hohlraumresonators 2 weist in ähnlicher Weise wie die obere Hälfte 201 Koppelschleifen auf, von denen nur die Koppelschleife 204 in der Fig. 6 sichtbar ist. Diese Koppelschleifen koppeln elektromagnetische Energie aus dem aus metallischem Material bestehenden Rechteckhohlleiter 6, an den ein nicht dargestellter Mikrowellensender angeschlossen ist, in den Hohlraumresonator 2 ein. Die Durchführung der Koppelschleifen 204 geschieht dabei durch elektrisch nichtleitende Dichtungen 205, 206. Die obere Hälfte 201 des Hohlraumresonators 2 und der Flansch 47 der Plasmakammer 3 sind über Verbindungselemente 207 miteinander verbunden. Desgleichen ist ein Weicheisenjoch 5 mit diesem Flansch 47 über Verbindungselemente, z. B. Schrauben 209 verbunden. Dieses Weicheisenjoch 5 Weist einen äußeren Schenkel 208 und einen inneren Schenkel 210 auf, wobei der äußere Schenkel 208 größer als der innere Schenkel 210 ist und wobei beide Schenkel 208, 210 eine Oberfläche 211, 212 mit 45°-Neigung aufweisen, die zueinander fluchten. Die Oberfläche 211 des größeren Schenkels 208 trägt einen Südpol 213 eines Dauermagneten, während die Oberfläche des kleineren Schenkels 210 den zugehörigen Nordpol 214 trägt. Mit 215 sind die magnetischen Feldlinien zwischen dem Nordpol 214 und dem Südpol 213 angedeutet. In dem äußeren Schenkel 208 ist ein rechteckiges Kühlrohr 216 integriert. Auf der Unterseite des Kleineren Schenkels 210 ist eine Vakuumdichtung 217 vorgesehen. Zwischen dem unteren Bereich des kleineren Schenkels 210 einerseits und der Oberseite der oberen Hälfte 201 des Hohlraumresonators 2 andererseits ist eine Pratze 218 vorgesehen, auf der eine Glas- oder Keramikscheibe 219 ruht. Zwischen dieser Scheibe 219 und der Pratze 218 befindet sich eine Graphitfolie 220. Eine weitere Graphitfolie 221 ist zwischen der Oberkante der Scheibe 219 und einer Unterkante des kleineren Schenkels 210 vorgesehen. An diese Folie 221 schließt sich in Richtung auf die Plasmakammer 3 eine Vakuumdichtung 222 an, die z. B. aus Metall, Calriz oder Viton bestehen kann. Durch die Scheibe 219 und die Oberseite des Hohlraumresonators 2 wird ein Raum 223 gebildet, in den über die Koppler 203, die durch elektrisch nichtleitende Materialien 224 im Hohlraumresonator 2 geführt sind, Mikrowellenenergie gelangt.

Bei der Anordnung gemäß Fig. 6 liegen die plasmaseitigen Koppler 203 hinter der Quarz- oder Keramikscheibe 219 und können somit unabhängig von Einflüssen aus der Plasmakammer 3 betrieben werden.

Bei der Anordnung gemäß Fig. 6 ergibt sich der Vorteil, daß die Antennen besser zum Resonanzbereich des Magnetfelds orientiert werden können, wobei die Ausbreitungsrichtung des Energietransports und die B-Feldrichtung, d. h. die Richtung des Magnetfelds des Dauermagneten, übereinstimmen.

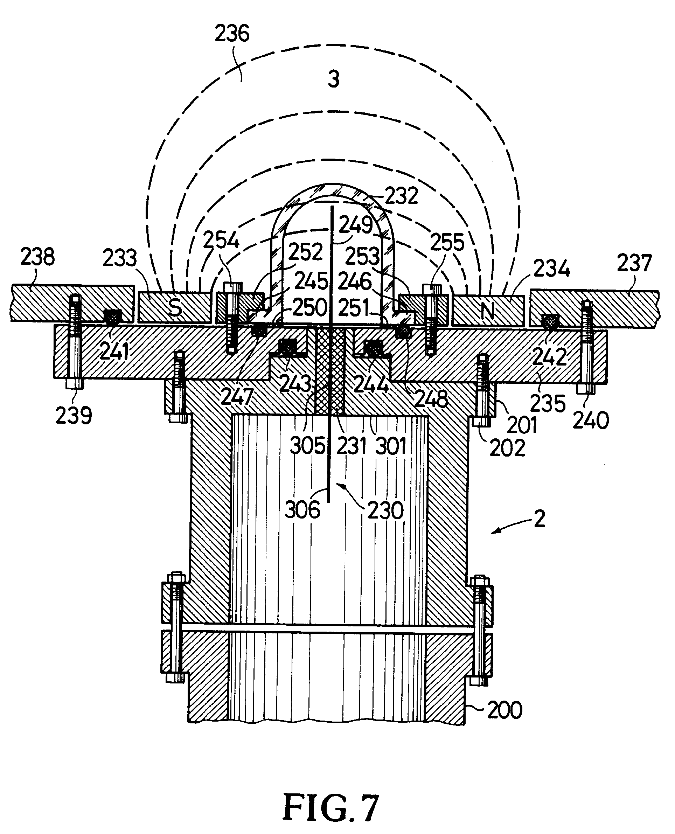

Die Fig. 7 zeigt eine weitere Variante der Erfindung, bei der mehrere schleifenförmige Koppler 230 im Hohlraumresonator 2 hintereinander angeordnet sind und durch elektrisch nichtleitende Durchführungen 231 in den Plasmaraum 3 ragen. Über jeden Koppler 230 ist dabei ein Quarz- oder Keramikdom 232 gestülpt. Diese Dome 232 befinden sich zwischen einem Südpol 233 und einem Nordpol 234 eines Dauermagneten, der mit einem Weicheisenjoch 235 in Verbindung steht, das auf der Oberseite des Hohlraumresonators 2 aufliegt. Die magnetischen Feldlinien, die zwischen Nord- und Südpol verlaufen, sind mit 236 bezeichnet. Das Weicheisenjoch 235 erstreckt sich über die gesamte Oberfläche des Hohlraumresonators 2 und trägt an seinen Enden die Kesselwände 237, 238 des Plasmaraums 3, die in der Fig. 7 nur angedeutet sind. Zwischen den Kesselwänden 237, 238 und dem Weicheisenjoch 235 besteht eine mechanische Verbindung, z. B. über Schrauben 239, 240. Außerdem sind Dichtungen 241, 242 zwischen dem Joch 235 und den nichtmagnetischen Kesselwänden 237, 238 vorgesehen. Weitere Dichtungen 243, 244 befinden sich im mittleren Teil der Oberseite des Hohlraumresonators 2 und der Unterseite des Jochs 235 sowie zwischen der Oberseite des Jochs 235 und seitlichen Flanschen 245, 246 am unteren Ende eines Doms 232. Diese letzteren Dichtungen sind mit 247 und 248 bezeichnet. Zwischen dem in den Dom 232 hineinragenden Teil 249 eines Kopplers 230 und den Dichtungen 247, 248 ist auf der Unterseite des Doms 232 noch eine Graphitscheibe 250, 251 vorgesehen.

Die Flansche 245, 246 werden durch nichtmagnetische Pratzen 252, 253, die über Schrauben 254, 255 mit dem Weicheisenjoch 235 verbunden sind, festgehalten.

Bei der Anordnung gemäß Fig. 7 liegen diese Koppler 230 zwischen den ungleichnamigen Dauermagnetpolen 233, 234. Hierdurch wird jede geradlinige Beschleunigungsstrecke eines Elektrons von einem Hohlleiterresonator versorgt. Es ist auch möglich, beide Pole der Dauermagneten von einem Ringresonator aus zu versorgen.

## Patentansprüche

1. Vorrichtung für die Erzeugung eines homogenen Mikrowellenfeldes über eine größere Strecke, mit
1.1 einem Mikrowellenerzeuger (7 bis 12)
1.2 einem Hohlraumresonator (2, 40, 121, 200, 201)
1.3 einer Ankopplung (6) für den Mikrowellenerzeuger (7 bis 12) an den Hohlraumresonator (2, 40, 121, 200, 201)
1.4 einer mit Wänden (47, 237, 238) begrenzten Kammer (3, 4, 41, 122)
1.5 einer Trennwand (29, 300, 301) aus elektrisch leitendem Material zwischen dem Hohlraumresonator (2, 40, 121, 200, 201) und der Kammer (3, 4, 41, 122)
1.6 einer aus mehreren als Festkörper ausgebildeten Koppelelementen (21 bis 28, 203, 204, 230) bestehenden Koppeleinrichtung, die elektromagnetische Energie von dem Hohlraumresonator (2, 40, 121, 200, 201) in die Kammer (3, 4, 41, 122) einkoppelt,
**dadurch gekennzeichnet**, daß
1.7 die Trennwand (29, 300, 301) den Hohlraumresonator (2, 40, 121, 200, 201) gasdicht von der Kammer (3, 4, 41, 122) trennt
1.8 in dem Hohlraumresonator (2, 40, 121, 200, 201) erste Elemente (z. B. 102, 203) vorgesehen sind, die elektromagnetische Energie aus dem Hohlraumresonator (2, 40, 121, 200, 201) aufnehmen können
1.9 in der Kammer (3, 4, 41, 122) zweite Elemente (z. B. 103, 249, 303) vorgesehen sind, die elektromagnetische Energie in die Kammer (3, 4, 41, 122) abgeben können
1.10 in der Trennwand (29, 300, 301 Durchbohrungen mit elektrisch nichtleitenden Verschlüssen (106, 224, 231) vorgesehen sind, wobei durch diese Verschlüsse (106, 224, 231) elektrisch leitende Verbindungen (111, 304, 305) geführt sind, welche die ersten Elemente (102, 203, 306) mit korrespondierenden zweiten Elementen verbinden.

2. Vorrichtung nach Anspruch 1, **dadurch gekennzeichnet**, daß die Koppelelemente (21 bis 28, 203, 204; 230) äquidistant angeordnet sind.

3. Vorrichtung nach Anspruch 2, **dadurch gekennzeichnet**, daß die Koppelelemente (21 bis 28, 203, 204, 230) linear und in einem Abstand von jeweils λ/4 angeordnet sind, wobei λ die Wellenlänge einer sich in dem Hohlraumresonator (2, 40, 121, 200, 201) ausbildenden stehenden Welle ist.

4. Vorrichtung nach Anspruch 3, **dadurch gekennzeichnet,** daß die Koppelelemente (21 bis 28, 203, 204, 230) induktive Auskoppler sind, die Mikrowellenenergie aus einer stehenden Welle im Hohlraumresonator (2) auskoppeln und kapazitiv oder induktiv ins Plasma wieder einkoppeln.

5. Vorrichtung nach Anspruch 3, **dadurch gekennzeichnet**, daß die Mikrowellenauskoppler kapazitive Auskoppler sind, die Mikrowellenenergie aus einer stehenden Welle im Hohlraumresonator (2) auskoppeln und kapazitiv oder induktiv ins Plasma wieder einkoppeln.

6. Vorrichtung nach Anspruch 1, **dadurch gekennzeichnet,** daß mehrere Hohlraumresonatoren vorgesehen sind, die über einen Speiseresonator miteinander verbunden sind und mit jeweils der gleichen Leistung versorgt werden.

7. Vorrichtung nach Anspruch 1, **dadurch gekennzeichnet**, daß mehrere parallel angeordnete Hohlraumresonatoren vorgesehen sind, die von kohärenten Magnetrons gespeist werden.

8. Vorrichtung nach Anspruch 1, **dadurch gekennzeichnet**, daß mehrere kolinear angeordnete Hohlraumresonatoren vorgesehen sind, die von kohärenten Magnetrons gespeist werden.

9. Vorrichtung nach den Ansprüchen 1, 7 und 8, **dadurch gekennzeichnet**, daß die Magnetrons Mikrowellen verschiedener Frequenz, aber gleicher Leistung abgeben.

10. Vorrichtung nach den Ansprüchen 1 und 3, **dadurch gekennzeichnet**, daß die Mikrowellenauskoppler, welche aus der negativen Halbwelle eine stehende Welle auskoppeln, gegenüber den Mikrowellenauskopplern, welche aus der positiven Halbwelle eine stehende Welle auskoppeln, eine Phasenumkehr aufweisen.

11. Vorrichtung nach Anspruch 1, **dadurch gekennzeichnet**, daß der Raum (3) durch einen Behälter definiert ist, der longitudinal von Magnetsystemen (4,5) umgeben ist, die ein cusp-Feld in dem Raum erzeugen, welches im Zusammenwirken mit der eingestrahlten Mikrowelle eine Elektronen-Zyklotron-Resonanz bewirkt.

12. Vorrichtung nach Anspruch 1, **dadurch gekennzeichnet,** daß die Wellenlänge der sich in dem Hohlraumresonator (2) aufbauenden stehenden Welle über den in dem Hohlraumresonator herrschenden und einstellbaren Gasdruck geregelt wird.

13. Vorrichtung nach Anspruch 1, **dadurch gekennzeichnet**, daß der zweite Raum (122) im Plasmaraum ist, in dem sich eine Dunkelraumkappe (112) befindet, die in der Nähe der Stromdurchführung (111) angeordnet ist.

14. Vorrichtung nach Anspruch 1, **dadurch gekennzeichnet**, daß ein Koppler eine Primärantenne (102) enthält, die im wesentlichen die Form einer offenen Schleife hat, wobei das eine Ende dieser offenen Schleife mit einer Stromdurchführung (111) verbunden ist, während das andere Ende dieser Schleife mit einer Buchse (104) in Verbindung steht, die durch die Trennwand (120) zwischen dem Hohlraumresonator (2, 40, 121, 200, 201) und dem Raum (3) geführt ist.

15. Vorrichtung nach Anspruch 1, **dadurch gekennzeichnet**, daß ein Koppler eine Sekundärantenne (103) enthält, die im wesentlichen die Form einer offenen Schleife hat, wobei das eine Ende (113) dieser offenen Schleife über die Dunkelraumkappe (112) mit der Stromdurchführung (111) verbunden ist, während das andere Ende (108) dieser Schleife mit einer Buchse (104) in Verbindung steht, die durch die Trennwand (120) zwischen dem ersten Raum (121) und dem zweiten Raum (122) geführt ist.

16. Vorrichtung nach Anspruch 1, **dadurch gekennzeichnet**, daß die Stromdurchführung (111) ein Stift ist, der einen ringförmigen Kragen (124) aufweist.

17. Vorrichtung nach Anspruch 1, **dadurch gekennzeichnet**, daß die Trennwand (120) sowie die Vorrichtung (101) aus nichtmagnetischen Werkstoffen bestehen.

18. Vorrichtung nach Anspruch 1, **dadurch gekennzeichnet**, daß zwischen der Kammer (3) und dem Hohlraumresonator (2) eine für Mikrowellen durchlässige Wand (219) vorgesehen ist, welche zwischen sich und dem Hohlraumresonator (2) einen Raum bildet, in den ein Koppler (303) hineinragt.

19. Vorrichtung nach Anspruch 18, **dadurch gekennzeichnet**, daß oberhalb der Wand (219) und an deren Rand der Nord- und Südpol (213, 214) eines Dauermagneten in einem Winkel von etwa 45 Grad angeordnet sind.

20. Vorrichtung nach Anspruch 18, **dadurch gekennzeichnet,** daß eine erste Reihe von Kopplern (204) vorgesehen ist, welche Mikrowellenenergie aus der Ankopplung (6) in den Hohlraumresonator (2) einkoppeln, und daß eine hiervon unabhängige zweite Reihe von Kopplern (203) vorgesehen ist, welche Mikrowellenenergie aus dem Hohlraumresonator (2) in den Raum (3) einkoppeln.

21. Vorrichtung nach Anspruch 1, **dadurch gekennzeichnet**, daß jedes Koppelelement (249) im Raum (3) mit einer Überdachung (232) versehen ist, die aus einem Material besteht, welches Gase und Festkörper sperrt und Mikrowellen durchläßt.

22. Vorrichtung nach Anspruch 21, **dadurch gekennzeichnet**, daß jedes Koppelelement (249) zwischen dem Nord- und Südpol (233, 234) eines Dauermagneten angeordnet ist.

## Claims

1. Apparatus for generating a homogeneous microwave field over a relatively long distance, having
1.1 a microwave generator (7 to 12),
1.2 a cavity resonator (2, 40, 121, 200, 201),
1.3 a means (6) of coupling the microwave generator (7 to 12) to the cavity resonator (2, 40, 121, 200, 201),
1.4 a chamber (3, 4, 41, 122) delimited by walls (47, 237, 238),
1.5 a dividing wall (29, 300, 301) of electrically conductive material between the cavity resonator (2, 40, 121, 200, 201) and the chamber (3, 4, 41, 122),
1.6 a coupling device which comprises a plurality of coupling elements (21 to 28, 203, 204, 230) constructed as solid bodies and which bunches electromagnetic energy from the cavity resonator (2, 40, 121, 200, 201) to the chamber (3, 4, 41, 122),
characterized in that
1.7 the dividing wall (29, 300, 301) divides the cavity resonator (2, 40, 121, 200, 201) from the chamber (3, 4, 41, 122) in gas-tight manner,
1.8 first elements (e.g. 102, 203) which can absorb electromagnetic energy from the cavity resonator (2, 40, 121, 200, 201) are provided in the cavity resonator (2, 40, 121, 200, 201),
1.9 second elements (e.g. 103, 249, 303) which can emit electromagnetic energy to the chamber (3, 4, 41, 122) are provided in the chamber (3, 4, 41, 122),
1.10 bores having electrically non-conductive closures (106, 224, 231) are provided in the dividing wall (29, 300, 301), there being guided through these closures (106, 224, 231) electrically conductive connections (111, 304, 305) which connect the first elements (102, 203, 306) to corresponding second elements.

2. Apparatus according to Claim 1, characterized in that the coupling elements (21 to 28, 203, 204; 230) are arranged equidistantly.

3. Apparatus according to Claim 2, characterized in that the coupling elements (21 to 28, 203, 204, 230) are arranged linearly and at a spacing in each case of λ/4, where λ is the wavelength of a standing wave forming in the cavity resonator (2, 40, 121, 200, 201).

4. Apparatus according to Claim 3, characterized in that the coupling elements (21 to 28, 203, 204, 230) are inductive catchers which catch microwave energy from a standing wave in the cavity resonator (2) and bunch it capacitively or inductively into the plasma again.

5. Apparatus according to Claim 3, characterized in that the microwave catchers are capacitive catchers which catch microwave energy from a standing wave in the cavity resonator (2) and bunch it capacitively or inductively into the plasma again.

6. Apparatus according to Claim 1, characterized in that a plurality of cavity resonators are provided, which are connected to one another by way of a supply resonator and are supplied with the same power in each case.

7. Apparatus according to Claim 1, characterized in that a plurality of cavity resonators which are arranged parallel and supplied by coherent magnetrons are provided.

8. Apparatus according to Claim 1, characterized in that a plurality of cavity resonators arranged colinearly and supplied by coherent magnetrons are provided.

9. Apparatus according to Claims 1, 7 and 8, characterized in that the magnetrons emit microwaves of different frequency but the same power.

10. Apparatus according to Claims 1 and 3, characterized in that the microwave catchers which catch a standing wave from the negative half wave have a phase inversion with respect to the microwave catchers which catch a standing wave from the positive half wave.

11. Apparatus according to Claim 1, characterized in that the space (3) is defined by a container which is surrounded longitudinally by magnet systems (4, 5) which generate a cusp field in the space, this field cooperating with the irradiated microwave to effect an electron cyclotron resonance.

12. Apparatus according to Claim 1, characterized in that the wavelength of the standing wave forming in the cavity resonator (2) is regulated by way of the gas pressure which prevails in the cavity resonator and is adjustable.

13. Apparatus according to Claim 1, characterized in that the second space (122) is in the plasma space in which there is a dark-space cap (112) which is arranged in the vicinity of the bushing (111).

14. Apparatus according to Claim 1, characterized in that a coupler has a primary antenna (102) which is substantially in the form of an open loop, the one end of this open loop being connected to a bushing (111), while the other end of this loop is connected to a socket (104) which is guided through the dividing wall (120) between the cavity resonator (2, 40, 121, 200, 201) and the space (3).

15. Apparatus according to Claim 1, characterized in that a coupler has a secondary antenna (103) which is substantially in the form of an open loop, the one end (113) of this open loop being connected by way of the dark-space cap (112) to the bushing (111), while the other end (108) of this loop is connected to a socket (104) which is guided through the dividing wall (120) between the first space (121) and the second space (122).

16. Apparatus according to Claim 1, characterized in that the bushing (111) is a pin which has an annular collar (124).

17. Apparatus according to Claim 1, characterized in that the dividing wall (120) and the apparatus (101) are of non-magnetic materials.

18. Apparatus according to Claim 1, characterized in that a wall (219) which is permeable to microwaves and which forms between itself and the cavity resonator (2) a spacing to which a coupler (303) projects is provided between the chamber (3) and the cavity resonator (2).

19. Apparatus according to Claim 18, characterized in that the north and south poles (213, 214) of a permanent magnet are arranged at an angle of approximately 45 degrees above the wall (219) and on the rim thereof.

20. Apparatus according to Claim 18, characterized in that a first row of couplers (204) which bunch microwave energy from the means (6) of coupling into the cavity resonator (2) is provided, and in that a second row of couplers (203), independent thereof, which bunches microwave energy from the cavity resonator (2) to the space (3) is provided.

21. Apparatus according to Claim 1, characterized in that each coupling element (249) in the space (3) is provided with a roofing means (232) which is made of a material which blocks gases and solid bodies and is permeable to microwaves.

22. Apparatus according to Claim 21, characterized in that each coupling element (249) is arranged between the north and south poles (233, 234) of a permanent magnet.

## Revendications

1. Dispositif pour la production d'un champ de micro-ondes homogène sur une longue distance, comportant
1.1 un générateur de micro-ondes (7 à 12),
1.2 une cavité résonante (2, 40, 121, 200, 201),
1.3 un couplage (6) pour le générateur de micro-ondes (7 à 12) sur la cavité résonante (2, 40, 121, 200, 201),
1.4 une chambre (3, 4, 41, 122) délimitée par des parois (47, 237, 238),
1.5 une cloison (29, 300, 301) en matériau conducteur électrique entre la cavité résonante (2, 40, 121, 200, 201) et la chambre (3, 4, 41, 122),
1.6 un dispositif de couplage composé de plusieurs éléments de couplage (21 à 28, 203, 204, 230) réalisés comme des solides, qui transmet l'énergie électromagnétique de la cavité résonante (2, 40, 121, 200, 201) dans la chambre (3, 4, 41, 122),
**caractérisé en ce que**
1.7 la cloison (29, 300, 301) sépare la cavité résonante (2, 40, 121, 200, 201) de la chambre (3, 4, 41, 122) de façon étanche aux gaz,
1.8 il est prévu dans la cavité résonante (2, 40, 121, 200, 201) des premiers éléments (par exemple 102, 103) qui peuvent absorber de l'énergie électromagnétique provenant de la cavité résonante (2, 40, 121, 200, 201),
1.9 il est prévu dans la chambre (3, 4, 41, 122) des seconds éléments (par exemple 103, 249, 303) qui peuvent dégager de l'énergie électromagnétique dans la chambre (3, 4, 41, 122),
1.10 il est prévu dans la cloison (29, 300, 301) des trous traversants avec des fermetures (106, 224, 231) non conductrices électriques, des raccords (111, 304, 305) conducteurs électriques étant passés à travers ces fermetures (106, 224, 231) et reliant les premiers éléments (102, 203, 306) à des seconds éléments correspondants.

2. Dispositif selon la revendication 1, caractérisé en ce que les éléments de couplage (21 à 28, 203, 204, 230) sont disposés de façon équidistante.

3. Dispositif selon la revendication 2, caractérisé en ce que les éléments de couplage (21 à 28, 203, 204, 230) sont disposés de façon linéaire à une distance de λ/4 chacun, λ étant la longueur d'onde d'une onde stationnaire qui se forme dans la cavité résonante (2, 40, 121, 200, 201).

4. Dispositif selon la revendication 3, caractérisé en ce que les éléments de couplage (21 à 28, 203, 204, 230) sont des découpleurs inductifs, qui peuvent découpler l'énergie des micro-ondes à partir d'une onde stationnaire dans la cavité résonante (2) et la retransmettre au plasma de façon capacitive ou inductive.

5. Dispositif selon la revendication 3, caractérisé en ce que les découpleurs de micro-ondes sont des découpleurs capacitifs, qui peuvent découpler l'énergie des micro-ondes à partir d'une onde stationnaire dans la cavité résonante (2) et la retransmettre au plasma de façon capacitive ou inductive.

6. Dispositif selon la revendication 1, caractérisé en ce qu'il est prévu plusieurs cavités résonantes, qui sont reliées entre elles par l'intermédiaire d'un résonateur d'alimentation et sont alimentées chacune avec la même puissance.

7. Dispositif selon la revendication 1, caractérisé en ce qu'il est prévu plusieurs cavités résonantes disposées en parallèle, qui sont alimentées par des magnétrons cohérents.

8. Dispositif selon la revendication 1, caractérisé en ce qu'il est prévu plusieurs cavités résonantes disposées de façon colinéaire, qui sont alimentées par des magnétrons cohérents.

9. Dispositif selon les revendications 1, 7 et 8, caractérisé en ce que les magnétrons émettent des micro-ondes de fréquence différente mais de puissance égale.

10. Dispositif selon les revendications 1 et 3, caractérisé en ce que les découpleurs de micro-ondes, qui découplent une onde stationnaire à partir de la demi-onde négative, présentent une inversion de phase par rapport aux découpleurs de micro-ondes qui découplent une onde stationnaire à partir de la demi-onde positive.

11. Dispositif selon la revendication 1, caractérisé en ce que l'espace (3) est défini par un conteneur qui est entouré longitudinalement par des systèmes d'aimants (4, 5), qui produisent dans l'espace un champ à lobes qui réalise, en coopération avec la micro-onde émise, une résonance gyromagnétique des électrons.

12. Dispositif selon la revendication 1, caractérisé en ce que la longueur d'onde de l'onde stationnaire qui s'établit dans la cavité résonante (2) est régulée par la pression de gaz réglable régnant dans la cavité résonante.

13. Dispositif selon la revendication 1, caractérisé en ce que le deuxième espace (122) est un espace à plasma, dans lequel se trouve un capuchon pour espace sombre (112) disposé à proximité du passage de courant électrique (111).

14. Dispositif selon la revendication 1, caractérisé en ce qu'un coupleur contient une antenne primaire (102), qui a pour l'essentiel la forme d'une boucle ouverte, une extrémité de cette boucle ouverte étant reliée à un passage de courant électrique (111), alors que l'autre extrémité de cette boucle est en liaison avec une douille (104) qui est passée à travers la paroi (120) entre la cavité résonante (2, 40, 121, 200, 201) et l'espace (3).

15. Dispositif selon la revendication 1, caractérisé en ce qu'un coupleur contient une antenne secondaire (103) qui a sensiblement la forme d'une boucle ouverte, une extrémité (113) de cette boucle ouverte étant reliée au passage de courant électrique (111) par l'intermédiaire du capuchon à espace sombre (112), alors que l'autre extrémité (108) de cette boucle est en liaison avec une douille (104) qui est passée à travers la cloison (120) entre le premier espace (121) et le deuxième espace (122).

16. Dispositif selon la revendication 1, caractérisé en ce que le passage de courant électrique (111) est une cheville qui présente un collet annulaire (124).

17. Dispositif selon la revendication 1, caractérisé en ce que la cloison (120) ainsi que le dispositif (101) se composent de matériaux non magnétiques.

18. Dispositif selon la revendication 1, caractérisé en ce qu'il est prévu entre la chambre (3) et la cavité résonante (2) une paroi (219) perméable aux micro-ondes, qui forme entre elle-même et la cavité résonante (2) un espace dans lequel un coupleur (303) fait saillie.

19. Dispositif selon la revendication 18, caractérisé en ce que le pôle nord et le pôle sud (213, 214) d'un aimant permanent sont disposés au-dessus de la paroi (219) et au bord de celle-ci selon un angle d'environ 45°.

20. Dispositif selon la revendication 18, caractérisé en ce qu'il est prévu une première rangée de coupleurs (204) qui transmettent l'énergie des micro-ondes à partir du découplage (6) vers la cavité résonante (2), et en ce qu'il est prévu une seconde rangée de coupleurs (203) indépendante de la précédente, qui transmettent l'énergie des micro-ondes de la cavité résonante (2) à l'espace (3).

21. Dispositif selon la revendication 1, caractérisé en ce que chaque élément de couplage (249) est pourvu dans l'espace (3) d'une couverture (232) qui se compose d'un matériau arrêtant les gaz et les solides et laissant passer les micro-ondes.

22. Dispositif selon la revendication 21, caractérisé en ce que chaque élément de couplage (249) est disposé entre les pôles nord et sud (233, 234) d'un aimant permanent.
